## Europäisches Patentamt

## European Patent Office

## Office européen des brevets

(11) Veröffentlichungsnummer: **0 158 197**

**A2**

(12) **EUROPÄISCHE PATENTANMELDUNG**

(21) Anmeldenummer: 85103430.6

(22) Anmeldetag: 22.03.85

(51) Int. Cl.⁴: **H 03 D 1/22**

(30) Priorität: 13.04.84 DE 3413902

(43) Veröffentlichungstag der Anmeldung:
16.10.85 Patentblatt 85/42

(84) Benannte Vertragsstaaten:
AT BE CH DE FR GB IT LI LU NL SE

(71) Anmelder: **Fried. Krupp Gesellschaft mit beschränkter Haftung**
**Altendorfer Strasse 103**
**D-4300 Essen 1(DE)**

(72) Erfinder: **Weiland, Walter**
**August-Bebel-Allee 3 B**
**D-2800 Bremen 41(DE)**

(54) Demodulator.

(57) Ein Demodulator zum Umsetzen eines Sinussignals in ein amplitudenproportionales Gleichspannungssignal weist einen mit Eingangswiderständen (14, 15) und einem Gegenkopplungswiderstand (13) beschalteten Operationsverstärker (12) und einen Feldeffektransistor (17) auf, der als Schalter zum Invertieren der Spannungsverstärkung des Operationsverstärkers (12) betrieben wird. Um eine sehr hohe Genauigkeit in der Amplitudenproportionalität der Ausgangsspannung ($U_A$) zu erhalten, ist zum einen der Gegenkopplungswiderstand (13) gleich der Summe aus dem Eingangswiderstand (14) am invertierenden Eingang des Operationsverstärkers (12) einerseits und dem mit dem zweifachen Durchlaßwiderstand des Feldeffektransistors (17) multiplizierten Widerstandsverhältnis der Eingangswiderstände (14 15) andererseits bemessen. Zum anderen ist der Eingangswiderstand (15) am nichtinvertierenden Eingang des Operationsverstärkers (12) in zwei Teilwiderstände (151, 152) aufgeteilt und der Anschluß des Feldeffekttransistors (17) an den Operationsverstärker (12) über den zweiten Teilwiderstand (152) geführt. Die Teilwiderstände (151 und 152) sind so bemessen, daß die Summe aus dem ersten Teilwiderstand (151) und dem doppelten zweiten Teilwiderstand (152) etwa dem Gegenkopplungswiderstand (13) entspricht.

FRIED. KRUPP GESELLSCHAFT MIT BESCHRÄNKTER HAFTUNG
in 4300 Essen


# D E M O D U L A T O R

Die Erfindung betrifft einen Demodulator der im Oberbegriff des Anspruchs 1 angegebenen Gattung.

Solche Demodulatoren oder Gleichrichter dienen dazu, ein Sinussignal bestimmter Frequenz in eine der Amplitude des Sinussignals proportionale Gleichspannung umzuwandeln. Hierzu wird der als Schalter betriebene Feldeffekttransistor oder FET derart angesteuert, daß während der positiven Halbwelle des Sinussignals der Schalter geöffnet und während der negativen Halbwelle der Schalter geschlossen ist bzw. umgekehrt. Die Ausgangsspannung des Operationsverstärkers wird dann üblicherweise auf einen Tiefpaß zum Ausfiltern der entstehenden Oberwellen gegeben.

Bei einem bekannten Demodulator der eingangs genannten Art sind zur Erzielung einer Spannungsverstärkung des Operationsverstärkers von 1 bei geöffnetem und ungefähr -1 bei geschlossenem Schalter der Eingangswiderstand am invertierenden Eingang des Operationsverstärkers und der Gegenkopplungswiderstand gleich groß bemessen. Der Eingangswiderstand am nichtinvertierenden Eingang des Operationsverstärkers entspricht etwa der Hälfte des anderen Eingangswiderstandes.

Der bekannte Demodulator ist bezüglich der amplitudenproportionalen Ausgangsspannung mit einem relativ hohen Fehler behaftet, der durch verschiedene Einflüsse hervorgerufen wird.

Der Erfindung liegt die Aufgabe zugrunde, einen Demodulator der eingangs genannten Art hinsichtlich der Genauigkeit bei der Umsetzung der Amplitude einer sinusförmigen Eingangsspannung in eine amplitudenproportionale Ausgangsspannung wesentlich zu verbessern.

Die Aufgabe ist bei einem Demodulator der im Oberbegriff des Anspruchs 1 definierten Gattung erfindungsgemäß durch die Merkmale im Kennzeichenteil des Anspruchs 1 und/oder des Anspruchs 2 gelöst.

Mit den kennzeichnenden Merkmalen im Anspruch 1 wird dabei ein Fehler in der Spannungsverstärkung des Operationsverstärkers beseitigt, der dadurch hervorgerufen wird, daß bei geschlossenem Schalter der Durchgangswiderstand des Feldeffekttransistors nicht unendlich klein ist, sondern einen nicht vernachlässigbaren Wert von z. B. 30 $\Omega$ aufweist. Dies hat zur Folge, daß die Spannungsverstärkung des Operationsverstärkers während der negativen Halbwelle des Sinussignals nicht den gleichen Betrag erreicht, wie während der positiven Halbwelle, sondern kleiner bleibt. Durch die erfindungsgemäße Auslegung des Gegenkopplungswiderstandes des Operationsverstärkers wird dieser Fehler vollständig kompensiert. Der Betrag der Spannungsverstärkung ist in jeder Halbwelle des Sinussignals gleich groß.

Mit den kennzeichnenden Merkmalen des Anspruchs 2 wird ein Fehler in der Ausgangsspannung des Operationsverstärkers kompensiert, der durch den Eingangsruhe- oder Bias-Strom des Operationsverstärkers hervorgerufen wird. Dieser Fehler äußert sich in einer von der Eingangsspannung unabhängigen Fehlerspannung (Offsetspannung) am Ausgang des Operationsverstärkers, die sich der Ausgangsspannung des Demodulators additiv überlagert und bei geöffnetem und geschlossenem Schalter unterschiedliche Beträge annimmt. Während die Offsetspannung bei geöffnetem Schalter nahezu verschwindet, nimmt sie bei geschlossenem Schalter einen von dem Eingangswiderstand am nichtinvertierenden Eingang des Operationsverstärkers und von dem Durchlaßwiderstand des FET abhängigen negativen Wert an. Dies bedeutet, daß die Ausgangsspannung während der negativen Halbwelle der Eingangsspannung nicht proportional deren Amplitude ist.

Durch die erfindungsgemäße Aufteilung des Eingangswiderstandes an dem nichtinvertierenden Eingang des Operationsverstärkers und der erfindungsgemäßen Auslegung der Teilwiderstände wird dieser Fehler der ungenauen Amplitudenproportionalität der Ausgangsspannung vollständig kompensiert, und zwar dadurch, daß in jeder Halbwelle der sinusförmigen Eingangsspannung am Demodulator der durch den Bias-Strom hervorgerufene Konstantspannungsfehler am Ausgang des Operationsverstärkers vom Betrag gleich groß ist. Die Amplitudenproportionalität der Ausgangsspannung wird dadurch im Mittel gewährt.

Alle Maßnahmen im Kennzeichenteil des Anspruchs 1 einerseits und im Kennzeichenteil des Anspruchs 2 andererseits verbessern die Genauigkeit des Demodulators. In der Kombination dieser Maßnahmen gemäß der
Ausführungsform des Demodulators nach Anspruch 3
wird eine Genauigkeit erzielt, die selbst extrem
hohen Anforderungen genügt.

Vorteilhafte Ausführungsformen der Erfindung ergeben
sich aus den Ansprüchen 4 und/oder 5. Durch diese
Maßnahmen läßt sich eine einfachere Dimensionierung
der Widerstände am Operationsverstärker erzielen.

Eine vorteilhafte Ausführungsform der Erfindung ergibt sich auch aus Anspruch 7. Durch diese Maßnahmen
werden die beiden Widerstände stets der gleichen Temperatur ausgesetzt, so daß ein Temperaturgang in den
beiden Widerständen, die besonders kritisch für die
Genauigkeit des Demodulators sind, kompensiert wird.

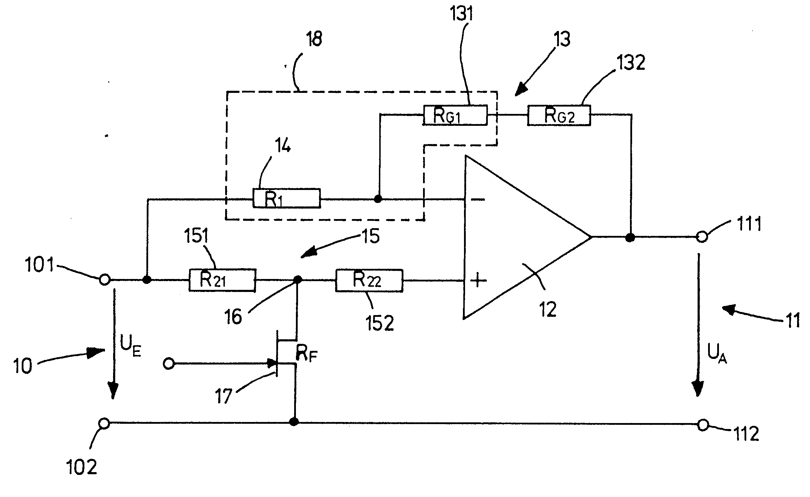

Die Erfindung ist anhand eines in der Zeichnung dargestellten Ausführungsbeispiels im folgenden näher
beschrieben. Dabei zeigt die Zeichnung ein Schaltbild eines Demodulators zum Umsetzen einer sinusförmigen Eingangsspannung $U_E$ in eine dem Betrag der Amplitude proportionale Ausgangsspannung $U_A$.

Der in der Zeichnung dargestellte Demodulator oder
Gleichrichter mit seinem Eingang 10 und seinem Ausgang 11 weist einen Operationsverstärker 12 auf,
dessen Ausgang über einen Gegenkopplungswiderstand 13
auf den invertierenden Eingang rückgekoppelt ist. Die
beiden Eingänge des Operationsverstärkers sind jeweils über einen Eingangswiderstand 14 bzw. 15 mit
einer den Signaleingang bildenden Anschlußklemme 101
des Eingangs 10 des Demodulators verbunden. Die andere am Bezugspotential des Eingangssignals liegende Anschlußklemme 102 des Eingangs 10 ist auf die eine Anschlußklemme 112 des Ausgangs 11 durchgeschaltet, während die andere Anschlußklemme 111 des Ausgangs 11 mit dem Ausgang des Operationsverstärkers 12 verbunden ist.

Der am nichtinvertierenden Eingang des Operationsverstärkers 12 angeschlossene Eingangswiderstand 15 ist in zwei Teilwiderstände 151 und 152 unterteilt. An dem Verbindungspunkt 16 zwischen den beiden Teilwiderständen 151 und 152 ist der Drain eines Feldeffekttransistors 17, im folgenden kurz FET 17 genannt, angeschlossen, dessen Source mit der Anschlußklemme 102 des Eingangs 10 bzw. der Anschlußklemme 112 des Ausgangs 11 des Demodulators verbunden ist, so daß der FET 17 über den zweiten Teilwiderstand 152 des Eingangswiderstandes 15 mit dem nichtinvertierenden Eingang des Operationsverstärkers 12 verbunden ist. Der FET 17 wird als Schalter intermittierend in der Weise betrieben, daß dieser während der positiven Halbwelle der am Eingang 10 des Demodulators anliegenden sinusförmigen Eingangsspannung $U_E$ geöffnet (FET 17 gesperrt) und während der negativen Halbwelle der Eingangsspannung $U_E$ geschlossen (FET 17 durchgängig) ist oder umgekehrt. Bei geöffnetem Schalter beträgt die Spannungsverstärkung des Operationsverstärkers "+1" und die Ausgangsspannung $U_A$ am Ausgang ist immer gleich der Eingangsspannung $U_E$. Im geschlossenen Zustand des Schalters, also bei durchgesteuertem FET 17, weist der FET 17 einen Durchlaßwiderstand auf, dessen Widerstandswert mit $R_F$ bezeichnet ist. Als Widerstandswerte werden hier und im folgenden ohmsche Widerstände verstanden. Der

Widerstandswert des Eingangswiderstandes 14 ist mit $R_1$, des Eingangswiderstandes 15 mit $R_2$ bzw. der Teilwiderstände 151 bzw. 152 mit $R_{21}$ bzw. $R_{22}$ und des Gegenkopplungswiderstandes 13 mit $R_G$. bezeichnet. Wie der Eingangswiderstand 15 ist auch der Gegenkopplungswiderstand 13 auf zwei Partialwiderstände 131 und 132 aufgeteilt, deren Widerstandswerte mit $R_{G1}$ und $R_{G2}$ bezeichnet sind.

Die Widerstandswerte sind nun so bemessen, daß sie den folgenden Gleichungen genügen:

$$R_G = R_1 + 2 R_F \cdot \frac{R_1}{R_{21}} \qquad (1),$$

$$R_G = R_{21} + 2 R_{22} \qquad (2),$$

wobei für Gl. (2) vorausgesetzt ist, daß der Widerstandswert $R_G$ des Gegenkopplungswiderstandes 13 annähernd gleich dem Widerstandswert $R_1$ des Eingangswiderstandes 14 ist ($R_G \approx R_1$).

Macht man den Widerstandswert $R_{G1}$ des Partialwiderstandes 131 des Gegenkopplungswiderstandes 13 sehr viel größer als den Widerstandswert $R_{G2}$ des Partialwiderstandes 132, so geht Gl. (2) über in

$$R_{G1} = R_{21} + 2 R_{22} \qquad (3),$$

wieder unter der Voraussetzung, daß $R_G \approx R_1$ ist. Unter sehr viel größer wird hier eine etwa größenordnungsmäßig unterschiedliche Bemessung, z. B. in $k\Omega$ einerseits und $\Omega$ andererseits, verstanden, so daß der durch Setzen von $R_{G1} = R_G$ gemachte Fehler klein ist.

Setzt man als erste Dimensionierungsregel

$$R_{G1} = R_1 \qquad (4)$$

so ergibt sich aus Gl. (1)

$$R_{G2} = 2\ R_F \cdot \frac{R_1}{R_{21}} \qquad (5)$$

und mit Gl. (3) die zweite Dimensionierungsregel

$$R_{G2} = 2\ R_F\ (1+ \frac{2\ R_{22}}{R_{21}}) \qquad (6).$$

Die dritte Dimensionierungsregel folgt aus der Umformung von Gl. (3) zu

$$R_{G1} = R_{21}\ (1+ \frac{2\ R_{22}}{R_{21}}) \qquad (7).$$

Bei Beachtung der Gl. (4), (6) und (7) wird für jedes gewählte Widerstandsverhältnis $R_{22}/R_{21}$ der Teilwiderstände 152 und 151 ein hochgenauer Demodulator erzielt, wenn nur der Widerstandswert $R_{G2}$ des Partialwiderstandes 132 sehr viel kleiner als der Widerstandswert $R_{G1}$ des Partialwiderstandes 131 bleibt. Der Demodulator hat bei geöffnetem und geschlossenem Schalter für jede Halbwelle des sinusförmigen Eingangssignals die betragsmäßig exakt gleiche Spannungsverstärkung von +1 bzw. -1 und eine durch den Bias-Strom hervorgerufene betragsmäßig gleich große, jedoch mit umgekehrtem Vorzeichen behaftete Offsetspannung, deren Größe ausschließlich von der Größe des gewählten Widerstandswertes $R_{21}$ des Teilwiderstandes 151 des Eingangswiderstandes 15 abhängt. Das gefilterte bzw. integrierte Ausgangssignal ist damit hochgenau proportional der Amplitude des Eingangssignals.

Ein Beispiel einer Dimensionierung der einzelnen
Widerstände bei einem Durchlaßwiderstand des FET 17
von $R_F$ = 30 $\Omega$ ist wie folgt:

$$R_1 = 60 \text{ k}\Omega$$

$$R_{G1} = 60 \text{ k}\Omega$$

$$R_{G2} = 180 \ \Omega$$

$$R_{21} = 20 \text{ k}\Omega$$

$$R_{22} = 20 \text{ k}\Omega$$

Hierbei beträgt bei geöffnetem Schalter (FET 17 gesperrt) die Spannungsverstärkung des Demodulators +1
und die Offsetspannung $U_{off}$ (V) = $I_B \cdot 20 \cdot 10^3$. Bei geschlossenem Schalter (FET 17 durchgängig) ist die
Spannungsverstärkung -1 und die Offsetspannung
$U_{off}$ (V) = $-I_B \cdot 20 \cdot 10^3$. Da der FET 17 während der positiven Halbwelle gesperrt (Schalter offen) und während der negativen Halbwelle durchgängig ist (Schalter geschlossen) ist die Ausgangsspannung $U_A$ im Mittel immer gleich $|U_E|$, so daß die Ausgangsspannung $U_A$
des Demodulators exakt proportional dem Betrag der
Amplitude der sinusförmigen Eingangsspannung $U_E$ ist.
Nach Filterung der Ausgangsspannung $U_A$ erhält man
dann eine Gleichspannung, die hochgenau proportional
der Amplitude der sinusförmigen Eingangsspannung $U_E$
ist.

Der Eingangswiderstand 14 am invertierenden Eingang
des Operationsverstärkers 12 und der Partialwiderstand 131 des Gegenkopplungswiderstandes 13 sind in Dünnfilmtechnik auf einem einzigen Chip 18 angeordnet, was in der Zeichnung durch strichlinierte Umrahmung symbolisiert ist. Dadurch wird ein Temperaturgang in diesen beiden Widerständen kompensiert und hat keine negativen Auswirkungen auf die Spannungsverstärkung des Operationsverstärkers 12.

Die Erfindung ist nicht auf das vorstehend beschriebene Ausführungsbeispiel beschränkt. Verzichtet man auf eine optimale Kompensation des durch den Bias-Strom hervorgerufenen Offsetfehlers, so kann auf eine Unterteilung des am nichtinvertierenden Eingang des Operationsverstärkers angeschlossenen Eingangswiderstandes 15 verzichtet werden. In diesem Fall ist der Drain des FET 17 unmittelbar an dem nichtinvertierenden Eingang des Operationsverstärkers 12 angeschlossen. Gl. (2) entfällt und Gl. (1) würde folgende Form annehmen:

$$R_G = R_1 + 2 R_F \cdot \frac{R_1}{R_2} \qquad (8).$$

Das auf Seite 11 angegebene Dimensionierungsbeispiel für die Widerstände würde danach wie folgt aussehen:

$$R_1 = 60 \ k\Omega$$
$$R_{G1} = 60 \ k\Omega$$
$$R_{G_2} = 120 \ \Omega$$
$$R_2 = 30 \ k\Omega.$$

Anstelle des leistungslos steuerbaren FET kann selbstverständlich auch ein anderer elektronischer Schalter, z. B. ein Transistor, eingesetzt werden.

## PATENTANSPRÜCHE

1. Demodulator mit einem gegengekoppelten Operationsverstärker, dessen Eingänge über jeweils einen Eingangswiderstand mit dem Signaleingang verbunden sind und in dessen Gegenkopplungszweig ein Gegenkopplungswiderstand angeordnet ist, und mit einem als intermittierender Schalter betriebenen Feldeffekttransistor, der zwischen dem nichtinvertierenden Eingang des Operationsverstärkers und dem Bezugspotential des Eingangssignals angeschlossen ist, dadurch gekennzeichnet, daß der Widerstandswert ($R_G$) des Gegenkopplungswiderstandes (13) gleich der Summe aus dem Widerstandswert ($R_1$) des Eingangswiderstandes (14) am invertierenden Eingang des Operationsverstärkers (12) einerseits und dem mit dem zweifachen Widerstandswert ($R_F$) des Durchlaßwiderstandes des Feldeffekttransistors (17) multiplizierten Widerstandswertverhältnisses ($R_1/R_2$) der Eingangswiderstände (14, 15) am invertierenden und nichtinvertierenden Eingang des Operationsverstärkers (12) andererseits bemessen ist.

2. Demodulator mit einem gegengekoppelten Operationsverstärker, dessen Eingänge über jeweils einen Eingangswiderstand mit dem Signaleingang verbunden sind und in dessen Gegenkopplungszweig ein Gegenkopplungswiderstand angeordnet ist, und mit einem als intermittierender Schalter betriebenen Feldeffekttransistor, der zwischen dem nichtinvertierenden Eingang des Operationsverstärkers und dem Bezugspotential des Eingangssignals angeschlossen ist, dadurch gekennzeichnet, daß der am nichtinvertierenden Eingang angeschlossene Eingangswiderstand (15) in zwei Teilwiderstände (151, 152) unterteilt und der Anschluß des Feldeffektransistors (17) an dem Operationsverstärker (12) über den am Eingang des Operationsverstärkers liegenden zweiten Teilwiderstand (152) vorgenommen ist und daß die Teilwiderstände (151, 152) derart bemessen sind, daß die Summe aus dem Widerstandswert ($R_{21}$) des ersten Teilwiderstands (151) einerseits und dem zweifachen Widerstandswert ($R_{22}$) des zweiten Teilwiderstandes (152) andererseits etwa gleich dem Widerstandswert ($R_G$) des Gegenkopplungswiderstandes (13) ist, der seinerseits annähernd gleich dem Widerstandswert ($R_1$) des Widerstands (14) am invertierenden Eingang des Operationsverstärkers (12) gewählt ist.

3. Demodulator nach Anspruch 2, dadurch gekennzeichnet, daß der Widerstandswert ($R_G$) des Gegenkopplungswiderstandes (13) gleich der Summe aus dem Widerstandswert ($R_1$) des Eingangswiderstandes (14) am invertierenden Eingang des Operationsverstärkers (12) einerseits und dem mit dem zweifachen Widerstandswert ($R_F$) des Durchlaßwiderstandes des Feldeffekttransistors (17) multiplizierten Widerstandswertverhältnisses ($R_1/R_{21}$) des Eingangswiderstandes (14) am invertierenden Eingang und des ersten Teilwiderstandes (151) des Eingangswiderstandes (15) am nichtinvertierenden Eingang des Operationsverstärkers (12) andererseits bemessen ist.

4. Demodulator nach einem der Ansprüche 1 bis 3,
dadurch gekennzeichnet, daß der Gegenkopplungswiderstand (13) auf zwei Partialwiderstände (131, 132) aufgeteilt ist und daß der
Widerstandswert ($R_{G1}$) des einen Partialwiderstandes (131) gleich dem Widerstandswert ($R_1$)
des Eingangswiderstandes (14) am invertierenden Eingang des Operationsverstärkers (12) und
sehr viel größer als der Widerstandswert ($R_{G2}$)
des anderen Partialwiderstandes (132) ist.

5. Demodulator nach Anspruch 2 oder 3 und 4, dadurch gekennzeichnet, daß bei der Bemessung der
Teilwiderstände (151, 152) des am nichtinvertierenden Eingang des Operationsverstärkers (12)
liegenden Eingangswiderstandes (15) nur der Widerstandswert ($R_{G1}$) desjenigen Partialwiderstandes (131) des Gegenkopplungswiderstandes (13)
berücksichtigt wird, dessen Widerstandswert ($R_{G1}$)
gleich dem des Eingangswiderstandes (14) am invertierenden Eingang des Operationsverstärkers
(12) ist.

6. Demodulator nach Anspruch 5, dadurch gekennzeichnet, daß die Widerstandswerte ($R_{21}$, $R_{22}$)
der Teilwiderstände (151, 152) gleich groß und
gleich einem Drittel des Widerstandswertes ($R_{G1}$)
desjenigen Partialwiderstandes (131) des Gegenkopplungswiderstandes (13) bemessen sind, dessen Widerstandswert ($R_{G1}$) gleich dem des Eingangswiderstandes (14) am invertierenden Eingang des Operationsverstärkers (12) ist.

7. Demodulator nach einem der Ansprüche 4 bis 6, dadurch gekennzeichnet, daß der Eingangswiderstand (14) am invertierenden Eingang des Operationsverstärkers (12) und der mit diesem widerstandswertgleiche Partialwiderstand (131) des Gegenkopplungswiderstandes (13) auf einem gemeinsamen Chip (18) in Dünnfilmtechnik ausgeführt sind.